# EUROPÄISCHE PATENTSCHRIFT

(11) **EP 3 362 586 B1**
(45) Veröffentlichungstag und Bekanntmachung des Hinweises auf die Patenterteilung: **26.02.2020**
(21) Anmeldenummer: 16788451.9
(22) Anmeldetag: 10.10.2016
(51) Int. Cl.: C23C 16/24, C01B 33/035, C23C 16/44, F16J 15/10, C23C 16/46

(54) **VORRICHTUNG ZUR ISOLIERUNG UND ABDICHTUNG VON ELEKTRODENHALTERUNGEN IN CVD REAKTOREN**
DEVICE FOR INSULATING AND SEALING ELECTRODE HOLDERS IN CVD REACTORS
DISPOSITIF D'ISOLEMENT ET D'ÉTANCHÉITÉ DE SUPPORTS D'ÉLECTRODE DANS DES RÉACTEURS CVD

(30) Priorität: 15.10.2015 DE 102015220127
(43) Veröffentlichungstag der Anmeldung: 22.08.2018
(73) Patentinhaber: Wacker Chemie AG, 81737 München (DE)
(72) Erfinder: RENNSCHMID, Dominik, 84489 Burghausen (DE); KRAUS, Heinz, 84367 Zeilarn (DE); KUTZA, Christian, 84539 Ampfing (DE)
(74) Vertreter: Belz, Ferdinand
(86) Internationale Anmeldenummer: PCT/EP2016/074230
(87) Internationale Veröffentlichungsnummer: WO 2017/064011

(56) Entgegenhaltungen:
- WO-A1-2014/143910

## Beschreibung

Die Erfindung betrifft eine Vorrichtung zur Isolierung und Abdichtung von Elektrodenhalterungen in einem Reaktor zur Abscheidung von polykristallinem Silicium sowie ein Verfahren zur Herstellung von polykristallinem Silicium mit Hilfe einer solchen Vorrichtung.

Hochreines Silicium wird in der Regel mittels des Siemens-Verfahrens hergestellt. Dabei wird ein Reaktionsgas enthaltend Wasserstoff und eine oder mehrere siliciumhaltige Komponenten in den Reaktor, bestückt mit dem durch den direkten Stromdurchgang erhitzen Trägerkörpern, eingeleitet, an denen sich Si in fester Form abscheidet. Als Silicium enthaltende Verbindungen werden bevorzugt Silan (SiH₄), Monochlorsilan (SiH₃Cl), Dichlorsilan (SiH₂Cl₂), Trichlorsilan (SiHCl₃), Tetrachlorsilan (SiCl₄) bzw. deren Mischungen eingesetzt.

Jeder Trägerkörper besteht meistens aus zwei dünnen Filamentstäben und einer Brücke, die in der Regel benachbarte Stäbe an ihren freien Enden verbindet. Am häufigsten werden die Filamentstäbe aus ein- oder polykristallinem Silicium gefertigt, seltener kommen Metalle bzw. Legierungen oder Kohlenstoff zum Einsatz. Die Filamentstäbe stecken senkrecht in am Reaktorboden befindlichen Elektroden über die der Anschluss an die Elektrodenhalterung und Stromversorgung erfolgt. An den erhitzten Filamentstäben und der waagrechten Brücke scheidet sich hochreines Polysilicium ab, wodurch deren Durchmesser mit der Zeit anwächst. Nachdem der gewünschte Durchmesser erreicht ist, wird der Prozess beendet.

Die Siliciumstäbe werden im CVD Reaktor von speziellen Elektroden gehalten, die in der Regel aus Graphit bestehen. Jeweils zwei Filamentstäbe mit unterschiedlicher Spannungspolung an den Elektrodenhalterungen sind am anderen Dünnstabende mit einer Brücke zu einem geschlossenen Stromkreis verbunden. Über die Elektroden und deren Elektrodenhalterungen wird elektrische Energie zur Beheizung der Dünnstäbe zugeführt. Dabei wächst der Durchmesser der Dünnstäbe. Gleichzeitig wächst die Elektrode, beginnend an ihrer Spitze, in den Stabfuß der Siliciumstäbe ein. Nach dem Erreichen eines gewünschten Solldurchmessers der Siliciumstäbe wird der Abscheideprozess beendet, die Siliciumstäbe abgekühlt und ausgebaut.

Eine besondere Bedeutung kommt der Abdichtung der durch die Bodenplatte geführten Elektrodenhalterung zu.
Austretendes Chlorsilan reagiert mit dem Sauerstoff und der Feuchte der Umgebungsluft zu Kieselsäure und HCL, welche mit weiterer Feuchte in Form von wässriger HCl kondensiert. Die Reaktionsprodukte, Kieselsäure und wässrige HCl, sowie durch HCl erzeugte Korrosionsprodukte schlagen sich am Ende der Durchführung der Elektrodenhalterung durch die Bodenplatte nieder und überbrücken die Isolierung der Elektrodenhalterung zur Bodenplatte, was zu einem Erdschluss und Ausfall des Abscheidereaktors führt.
Da sich die Reaktionsprodukte am Ort der Bildung ansammeln, können bereits kleinste Undichtigkeiten und Leckageströme bei einer angestrebten Betriebsdauer des Abscheidereaktors (Standzeit zwischen 2 Revisionen) über mehrere Monate zum vorzeitigen Ausfall durch Erdschluss führen. Bei der Betrachtung des Leckagestroms muss neben der Leckage an den Dichtungsflächen auch die Leckage durch Diffusion durch den Dichtungswerkstoff selbst betrachtet werden.
Zu diesem Zweck ist der Einsatz von Dichtungskörpern vorgeschlagen worden, wobei insbesondere der Anordnung und der Form der Dichtungskörper sowie dem verwendeten Dichtungswerkstoff Bedeutung zukommt.

Zwischen dem in die Abscheideanlage hinein ragenden Kopf der Elektrodenhalterung und der Bodenplatte befindet sich ein ringförmiger Körper. Dieser hat üblicherweise zwei Funktionen: 1. Abdichtung der Durchführung der Elektrodenhalterung und 2. elektrische Isolation der Elektrodenhalterung zur Bodenplatte hin.

Aufgrund der hohen Gasraumtemperatur im CVD-Reaktor ist ein thermischer Schutz eines auf Kohlenwasserstoff basierenden Dichtkörpers notwendig. Ungenügende thermische Schutzwirkung bedeutet vorzeitigen Verschleiß der Dichtkörper durch Verschmoren der Dichtkörper, thermisch bedingtes Fließen des Dichtkörpers, Undichtigkeit des Reaktors, Unterschreiten des Mindestabstands zwischen Elektrodenhalterung und Bodenplatte und Erdschluss an verkohlten Dichtkörpern. Erdschluss oder Undichtigkeiten haben einen Ausfall der Abscheideanlage und damit einen Abbruch des Abscheideprozesses zur Folge. Dies verursacht eine verminderte Ausbringung, geringere Ausbeute aufgrund von Materialabwertungen und höhere Kosten.

Aus US 20110305604 A1 ist bekannt, die Dichtungen der Elektroden mittels Schutzringen aus Quarz gegen thermische Belastung abzuschirmen. Der Reaktorboden weist eine spezielle Ausgestaltung auf. Der Reaktorboden umfasst einen ersten Bereich und einen zweiten Bereich. Der erste Bereich ist durch eine dem Innenraum des Reaktors zugewandte Platte und einer Zwischenplatte, die die Düsen trägt, gebildet. Der zweite Bereich des Reaktorbodens ist durch die Zwischenplatte und eine Bodenplatte, die die Versorgungsanschlüsse für die Filamente trägt, gebildet. In den so gebildeten ersten Bereich wird das Kühlwasser geführt, um somit den Reaktorboden zu kühlen. Die Filamente selbst sitzen in einem Graphitadapter. Dieser Graphitadapter greift in einen Graphitspannring ein, der selbst über einen Quarzring mit der Platte zusammenwirkt. Die Kühlwasseranschlüsse für die Filamente können in Form von Schnellkupplungen ausgebildet sein.

WO 2011092276 A1 beschreibt eine Elektrodenhalterung, bei der das Dichtelement zwischen Elektrodenhalterung und Bodenplatte durch einen umlaufenden Keramikring vor Temperatureinflüssen geschützt wird. Mehrere Elektroden sind in einem Boden des Reaktors befestigt. Die Elektroden tragen dabei Filamentstäbe, die in einem Elektrodenkörper sitzen und über den die Stromzufuhr zu den Elektroden bzw. Filamentstäben erfolgt. Der Elektrodenkörper selbst ist mit mehreren elastischen Elementen in Richtung der Oberseite des Bodens des Reaktors hin mechanisch vorgespannt. Zwischen der Oberseite des Bodens des Reaktors und einem zur Oberseite des Bodens parallelen Ring des Elektrodenkörpers ist ein radial umlaufendes Dichtelement eingesetzt. Das Dichtelement selbst ist im Bereich zwischen der Oberseite des Bodens des Reaktors und dem dazu parallelen Ring des Elektrodenkörpers von einem Keramikring abgeschirmt.
Das Dichtelement besteht aus PTFE und übernimmt zugleich Dicht- und Isolierfunktion. Der Keramikring dient als Hitzeschild für den Dichtring.
Allerdings führt eine thermische Belastung von PTFE über 250 °C zum Verschmoren / Cracken an der Dichtungsoberfläche sowie zum Fließen des Dichtkörpers. Dadurch unterschreitet der Abstand zwischen Kopf der Elektrodenhalterung und Bodenplatte einen Mindestabstand und führt zu elektrischen Überschlägen/Erdschlüssen von Elektrodenhalterung zur Bodenplatte. Das Verschmoren / Cracken setzt zudem Kohlenstoffverbindungen frei, die zu einer Verunreinigung der abzuscheidenden Siliciumstäbe durch Einbau von Kohlenstoff führen.

US 20130011581 A1 offenbart eine Vorrichtung zum Schutz von Elektrodenhalterungen in CVD Reaktoren, umfassend eine zur Aufnahme eines Filamentstabs geeigneten Elektrode auf einer Elektrodenhalterung aus einem elektrisch leitfähigen Material, die in einer Aussparung einer Bodenplatte angebracht ist, wobei ein Zwischenraum zwischen Elektrodenhalterung und Bodenplatte mit einem Dichtungsmaterial abgedichtet ist und das Dichtungsmaterial durch einen ein- oder mehrteilig aufgebauten, ringförmig um die Elektroden angeordneten Schutzkörper geschützt wird, wobei der Schutzkörper in Richtung der Elektrodenhalterung zumindest abschnittsweise in seiner Höhe zunimmt. Dabei sind geometrische Körper in konzentrischer Anordnung um die Elektrodenhalterung vorgesehen, deren Höhe mit zunehmendem Abstand von der Elektrodenhalterung abnimmt. Es kann sich auch um einen einteiligen Körper handeln. Dies dient dem thermischen Schutz des Dichtungs- und Isolierungskörpers der Elektrodenhalterung sowie einer Strömungsmodifikation am Stabfuß der abgeschiedenen Polysilicium-Stäbe, die die Umfallquote positiv beeinflusst.

Bei den Vorrichtungen nach WO 2011092276 A1 und nach US 20130011581 A1 kann es zwischen Elektrodenhalterung und Bodenplatte zu einem Erdschluss infolge von Siliciumsplittern kommen, die aufgrund von thermischen Verspannungen wegen des hohen Feeddurchsatzes von den Siliciumstäben abplatzen, zwischen Elektrodenhalterung und Keramikring / Schutzkörper fallen und dort eine elektrisch leitende Verbindung zwischen Elektrodenhalterung und Bodenplatte herstellen. Kurzschlüsse bedeuten ein abruptes Prozessende durch Ausfall der Stromversorgung zur Beheizung der Stäbe. Die Stäbe können nicht bis zum vorgesehenen Enddurchmesser abgeschieden werden. Mit dünneren Stäben fällt die Anlagenkapazität niedriger aus, was erhebliche Kosten verursacht.

CN 202193621 U offenbart eine Vorrichtung, bei der zwei Keramikringe zwischen Kopf der Elektrodenhalterung und Bodenplatte mit dazwischen liegender Graphitflachdichtung vorgesehen sind.

Hier besteht allerdings keine Dichtfunktion zwischen Keramikring und Kopf der Elektrodenhalterung sowie zwischen Keramikring und Bodenplatte. Undichtigkeiten des Reaktors sind die Folge.

CN 101565184 A offenbart einen Isolierring aus Zirkonoxidkeramik (ZrO2) zwischen Kopf der Elektrodenhalterung und der Bodenplatte. Der Isolierring ist in der Bodenplatte versenkt. Deshalb ist ein zusätzlicher Quarzring zur Isolierung zwischen Kopf der Elektrodenhalterung und Bodenplatte notwendig. Die Abdichtung erfolgt mittels zweier Graphitflachdichtungen zwischen Kopf der Elektrodenhalterung und Isolierring sowie zwischen Bodenplatte und Isolierring. Als zusätzliche Abdichtung wird ein O-Ring an der Elektrodendurchführung unterhalb der Bodenplatte eingesetzt.

CN 102616783 A offenbart einen Isolierring aus Keramik zwischen Kopf der Elektrodenhalterung und der Bodenplatte. Die Abdichtung erfolgt mittels zweier metalleingefasster Graphitflachdichtungen ober- und unterhalb des Isolierrings zum Kopf der Elektrodenhalterung bzw. zur Bodenplatte hin.

Bei den beiden zuletzt genannten Schriften besteht die Problematik, dass eine hohe Flächenpressung für die Graphitflachdichtung zur Abdichtung notwendig ist. Da Keramik spröde ist und eine geringe Biegefestigkeit aufweist, werden hohe Anforderungen an die Ebenheit der Dichtflächen von Bodenplatte und Kopf der Elektrodenhalterung gestellt. Bei kleinsten Unebenheiten, die in der Praxis kaum zu vermeiden sind, und hohen Anzugsmomenten kommt es zu hoher Punktlast und zum Bruch der Keramikringe. Undichtigkeiten des Reaktors sind die Folge.

WO 2014/143910 A1 offenbart einen Dichtungsring zwischen Bodenplatte und Elektrodenhalterung umfassend einen Grundkörper aus einem keramischen Material mit einer oberen und einer unteren Nut, wobei in die Nuten jeweils Dichtungselemente eingesetzt werden.

Allerdings schwächen zwei gegenüberliegende Nuten die mechanischen Eigenschaften des Isolierrings. Dies kann beim Verpressen, insbesondere bei unebenen Dichtflächen, zum Bruch des Isolierrings führen. Das Anbringen der Nuten im keramischen Werkstoff mit den dazugehörigen konstruktiven Vorgaben (Maßhaltigkeit, geringe Oberflächen - Rauigkeit) ist sehr kostenintensiv. Weiterhin ist die Anforderung an die Gegendichtfläche (Kopf der Elektrodenhalterung und Bodenplatte) ebenfalls sehr hoch. Dies verursacht zusätzliche Kosten.

US 2010058988 A1 sieht eine Fixierung der Elektrodenhalterung in der Bodenplatte durch ein konisches PTFE-Dicht- und Isolierelement vor. Das konische PTFE-Dichtelement wird an seiner Oberseite über einen Bund (Querschnittserweiterung) an der Elektrodenhalterung verpresst. Zusätzlich ist zwischen Dichtelement und Elektrodendurchführung durch die Bodenplatte sowie zwischen Dichtelement und Schaft der Elektrodenhalterung jeweils ein O-Ring vorgesehen.
Durch die Verpressung des konischen Dichtelements ist jedoch der Ausbau der Elektrodenhalterung erschwert. Durch Fließen des PTFE-Dichtkörpers kann der Mindestabstand zwischen Elektrodenhalterung und Bodenplatte unterschritten werden. Elektrische Überschläge / Erdschlüsse sind die Folge.

Aus dieser Problematik ergab sich die Aufgabenstellung der Erfindung.

Die Aufgabe wird gelöst durch eine Vorrichtung zur Isolierung und Abdichtung von Elektrodenhalterungen (1) befindlich in CVD Reaktoren, umfassend eine zur Aufnahme eines Filamentstabs geeignete Elektrode auf einer Elektrodenhalterung (1) aus einem elektrisch leitfähigen Material, die in einer Aussparung einer Bodenplatte (3) angebracht ist, wobei zwischen Elektrodenhalterung (1) und Bodenplatte (3) ein elektrisch isolierender Ring (2) aus einem Werkstoff mit einer spezifischen Wärmeleitfähigkeit bei Raumtemperatur von 0,2 - 50 W/mK, einer Mindestbiegefestigkeit von größer als 120 MPa und einem spezifischen elektrischen Widerstand bei Raumtemperatur von größer als 10⁹ Ωcm vorgesehen ist, wobei mindestens zwei ringförmige Dichtelemente (4, 5) zur Abdichtung zwischen Elektrodenhalterung (1) und Bodenplatte (3) vorhanden sind, wobei die mindestens zwei ringförmige Dichtelemente (4, 5) nicht auf derselben Seite des elektrisch isolierender Ring (2) liegen und wobei der elektrisch isolierende Ring (2) oder die Elektrodenhalterung (1) oder die Bodenplatte (3) wenigstens eine Nut (10) umfasst, in denen ein erstes Dichtelement (4) fixiert ist, dadurch gekennzeichnet, dass wenigstens ein zweites nicht in einer Nut fixiertes Dichtelement (5) zwischen elektrisch isolierendem Ring und Bodenplatte oder zwischen elektrisch isolierendem Ring und Elektrodenhalterung vorhanden ist.

Die Aufgabe der Erfindung wird auch gelöst durch ein Verfahren zur Herstellung von polykristallinem Silicium, umfassend Einleiten eines Reaktionsgases enthaltend eine Silicium enthaltende Komponente und Wasserstoff in einen CVD Reaktor enthaltend wenigstens einen Filamentstab, der sich auf einer erfindungsgemäßen Vorrichtung oder auf einer Vorrichtung gemäß einer der bevorzugten Ausführungsformen befindet, der mittels der Elektrode mit Strom versorgt und der damit durch direkten Stromdurchgang auf eine Temperatur aufgeheizt wird, bei der sich polykristallines Silicium am Filamentstab abscheidet.

Bevorzugte Ausführungsformen der Erfindung sind den anhängigen Ansprüchen und der nachfolgenden Beschreibung zu entnehmen.

Die Erfindung sieht vor, Dicht- und Isolierkörper zu trennen bzw. Dicht- und Isolierfunktionen auf mehrere Bauteile aufzuteilen, wobei ein Isolierring für die elektrische Isolation und zwei Dichtelemente für die Abdichtung gegenüber Bodenplatte und Elektrodenhalterung vorgesehen sind.

Dies ermöglicht es, für Isolierring und Dichtungsteil unterschiedliche Werkstoffe zu wählen, die für die jeweiligen Funktionen der beiden Bauteile besser geeignet sind.

Abweichend vom Stand der Technik befindet sich nur eines der Dichtelemente in einer Nut des Isolierrings oder in einer Nut von Bodenplatte oder Elektrodenhalterung. Entweder die Abdichtung gegen die Bodenplatte oder die Abdichtung gegen die Elektrodenhalterung erfolgen durch in einer Nut fixiertes Dichtelement, jedoch nicht sowohl die Abdichtung gegen die Bodenplatte als auch gegen die Elektrodenhalterung.

Auf der gegenüberliegenden Seite des Isolierrings erfolgt die Abdichtung gegen Bodenplatte oder Elektrodenhalterung mittels eines Dichtelements, das nicht in einer Nut von Isolierring, Bodenplatte oder Elektrodenhalterung fixiert ist. Im einfachsten Fall handelt es sich bei diesem Dichtelement um eine Flachdichtung.

Der Isolierring sollte hochtemperaturbeständig und formstabil sein, während eine abdichtende Funktion nicht notwendig ist. Durch die höhere Formstabilität gegenüber elastomeren Isolierkörpern können höhere Isolierringe verwendet werden. Der größere Abstand zwischen Elektrodenhalterung und Bodenplatte erlaubt das Anlegen von höherer elektrischer Spannung. Dies hat den Vorteil, dass mehrere Stabpaare in Reihe verschaltet werden können und somit Investitionskosten bei der Stromversorgung des Reaktors eingespart werden können.
Der Kopf der Elektrodenhalterung kann in einer Ausführungsform gegenüber dem Isolierring einen Überstand c haben. Dies sorgt für einen weiteren thermischen und mechanischen Schutz. Der Isolierring wird vor Wärmestrahlung abgeschattet und weniger stark belastet. Auch die Temperaturbelastung der Dichtelemente nimmt ab.

Ein Überstand ist dann gegeben, wenn der Außendurchmesser D_E der Elektrodenhalterung größer ist als der Außendurchmesser D_R des Isolierrings.

Die Nut zur Aufnahme des ersten Dichtelements kann sowohl im Isolierring als auch in der Bodenplatte und/oder im Kopf der Elektrodenhalterung sein.

In einer Ausführungsform befindet sich die Nut im Isolierring und nimmt ein Dichtelement auf, um Isolierring und Elektrodenhalterung abzudichten. Ein zweites Dichtelement befindet sich zwischen der der Nut gegenüberliegenden Seite des Isolierrings und der Bodenplatte.

In einer anderen Ausführungsform befindet sich die Nut in der Elektrodenhalterung und nimmt ein Dichtelement auf, um Isolierring und Elektrodenhalterung abzudichten. Ein zweites Dichtelement befindet sich zwischen der der Bodenplatte zugewandten Seite des Isolierrings und der Bodenplatte.
Die Nut befindet sich vorzugweise in einem Abstand a von 10-40% der Gesamtbreite b des Isolierrings zur Elektrodendurchführung (Innendurchmesser Isolierring). Dadurch ist das Dichtelement ausreichend weit von der dem Reaktor zugewandten Seite des Isolierrings entfernt. Dies ist in Hinblick auf die thermische Belastung der Dichtelemente von Vorteil.

In einer weiteren Ausführungsform kann die Nut auch an gleicher Position (Abstand a von 10-40% der Gesamtbreite b des Isolierrings zur Elektrodendurchführung) in der Bodenplatte oder im Kopf der Elektrodenhalterung sein. Der Isolierring hat in diesem Fall keine Nut.

Das in einer Nut fixierte Dichtelement wird vorzugweise vom Kühlmedium in der Bodenplatte und/oder dem Kühlmedium im Kopf der Elektrodenhalterung und der Durchführung der Elektrode gekühlt. Aufgrund der Kühlung nehmen die Dichtelemente eine deutlich geringere Temperatur als der Isolierring an.

Als Dichtelemente in der Nut eignen sich insbesondere ein O-Ring aus FFKM (Perfluorkautschuk), ein Graphitfolienring, eine mit Graphit gefüllte Spiraldichtung oder ein Metall C-Ring.

Bevorzugt ist ein mit Silber beschichteter Metall-C-Ring mit oder ohne innen liegende Spiralfeder.

Besonders bevorzugt ist die Verwendung eines Graphitfolienrings.

Als zweites, nicht in einer Nut fixiertes Dichtelement wird eine Flachdichtung eingesetzt. Diese Flachdichtung kann aus Graphit oder aus PTFE, bevorzugt aus Graphit gefertigt sein. Bevorzugt hat die Flachdichtung an ihren Rändern mindestens einen Metallbördel, wobei ein Metallbördel bevorzugt an der dem Reaktorraum zugewandten Seite angebracht ist. Besonders bevorzugt handelt es sich um eine Flachdichtung aus Graphit mit einer reaktorseitigen Metallbördelung. In einer Ausführungsform befindet sich diese Flachdichtung zwischen Isolierring und Bodenplatte.

Die dem Reaktorinnenraum zugewandte Seite des Isolierrings hat eine Oberflächentemperatur von bis zu 600°C. Die Dichtelemente sollten daher einer Dauertemperaturbelastung von größer als 250 °C standhalten.

Eine geringe Wärmeleitfähigkeit des Isolierrings begünstigt die niedrige Temperaturbelastung der Dichtelemente.

Die Flachdichtung dient zum Ausgleich von Fertigungsungenauigkeiten (Unebenheiten) der Gegendichtfläche, wie sie bei großen Werkstücken (Bodenplatten) im Apparatebau mit Standardverfahren (z. B. Drehen, Bohren, Schweißen) üblich sind. Eine weitergehende Feinbearbeitung (z. B. Schleifen, Polieren,) erhöht die Fertigungskosten der Apparate.

Demgegenüber können kleine Bauteile (Kopf der Elektrodenhalterung) ohne wesentliche Mehrkosten feinbearbeitet werden, sodass hier kein Ausgleich von Fertigungsungenauigkeiten notwendig ist.

Der Kopf der Elektrodenhalterung wird üblicherweise schlechter gekühlt als die Bodenplatte. Deshalb ist es vorteilhaft, wenn das Dichtelement zwischen Isolierring und Kopf der Elektrodenhalterung besser vor thermischer Belastung aus dem Reaktorraum geschützt wird. Dies kann in einer bevorzugten Ausführungsform durch die Platzierung des Dichtelements in einer Nut, wobei die Nut im Isolierring oder im Kopf der Elektrodenhalterung zurückgesetzt ist, erreicht werden.

Die Nut befindet sich in einem Abstand a von 10-40% der Gesamtbreite b des Isolierrings zur Elektrodendurchführung (Innendurchmesser Isolierring). Weiterhin wird durch eine Kammerung des Dichtelements durch die Nut die Diffusion von Reaktionsgas durch das Dichtelement minimiert, da für die Diffusion nur ein sehr geringer Überstand des Dichtelements aus der Nut f von 0 - 1 mm, bevorzugt von 0- 0,3 mm, maximal zulässig ist.

Je nach Art des Dichtungskörpers in der Nut sind 2 Anwendungsfälle möglich. In einem 1. Anwendungsfall haben Metall C-Ringe und O-Ringe nach der Verpressung einen Überstand f von 0 mm. Hier erfolgt die Kraftübertragung nicht über den Dichtkörper, sondern am Dichtkörper vorbei im Kraftnebenschluss. Je nach Lage der Nut erfolgt die Kraftübertragung zwischen Elektrodenhalterung und Stützring oder Stützring und Bodenplatte.

In einem 2. Anwendungsfall haben Graphitfolienringe oder Spiraldichtungen eine größere Dicke als die Nuttiefe. Aufgrund der plastischen Verformung der Dichtkörper während der Verpressung beginnt der aus der Nut überstehende Teil der Dichtung zu fließen Dabei wird der ursprüngliche Überstand des Dichtkörpers F im unverpresstem Zustand im Laufe der Verpressung auf einen kleineren, bleibenden Überstand f > 0 und ≤1 mm gestaucht. Gleichzeitig fließt Dichtungsmaterial bei Position der Nut in der Elektrodenhalterung oder im Stützring auf der Seite zur Elektrodenhalterung in den Spalt mit Dicke f >0 mm und ≤1 mm zwischen Elektrodenhalterung und Stützring.
Bei Position der Nut in der Bodenplatte oder im Stützring auf der Seite zur Bodenplatte fließt bei der Verpressung entsprechend Dichtungsmaterial in den Spalt mit Dicke f >0 mm und ≤1 mm zwischen Stützring und Bodenplatte.
Durch das Fließen des Dichtkörpers erhöht sich die Breite des Dichtkörpers auf den Wert e im Dichtungsspalt um 5 -100%, bevorzugt 5 -70% bezogen auf die Breite der Nut, bzw Breite des Dichtkörpers in unverpresstem Zustand E. Durch das Fließen des Dichtkörpers im Dichtungsspalt während der Verpressung füllt der Dichtungswerkstoff kleinste Unebenheiten der abzudichtenden Flächen von Stützring und / oder Bodenplatte aus. Weiterhin wird durch das Fließen des Dichtungswerkstoffs die Dichtfläche erhöht. Beide Effekte, Ausgleichen von Unebenheiten und größere Dichtfläche bewirken eine vollständige Abdichtung der Grenzflächen zwischen Dichtungskörper und Stützring sowie zwischen Dichtungskörper und Elektrodenhalterung oder zwischen Dichtungskörper und Bodenplatte. Da zu jedem Zeitpunkt der Verpressung. der Überstand f des Dichtkörpers > 0 mm und ≤ 1 mm ist, erfolgt die Kraftübertragung über den Dichtkörper im Krafthauptschluss.
Als weiteren thermischen und mechanischen Schutz kann der Kopf der Elektrodenhalterung über die Außenkontur des Isolierrings hinausragen. Der Überstand c kann 0 bis 30 mm betragen.

In einer Ausführungsform beträgt der Überstand 0 bis 15 mm.

Im Vergleich zu einem einteiligen Dicht- und Isolierring, können die Materialeigenschaften bei mehrteiligen Konstruktionen besser auf die jeweiligen Anforderungen an die Dicht- und Isolierfunktion ausgelegt werden.

Der Isolierring benötigt keine abdichtenden Materialeigenschaften. Deshalb ist man nicht an PTFE gebunden und kann Werkstoffe mit höherer Formstabilität und Temperaturbeständigkeit einsetzten. Die Temperaturbeständigkeit im Dauerbetrieb von PTFE liegt bei 250 °C. Die Keramikwerkstoffe besitzen dagegen eine Temperaturbeständigkeit im Dauerbetrieb von >1000°C und eine höhere Formstabilität.

Die spezifische Wärmeleitfähigkeit bei Raumtemperatur des Isolierrings liegt im Bereich von 0,2 - 50 W/mK, bevorzugt 0,2 - 20 W/mK, besonders bevorzugt 0,2 - 5 W/mK.

Der spezifische elektrische Widerstand des Isolierrings bei Raumtemperatur ist größer als 10⁹ Ωcm, vorzugsweise größer als 10¹¹ Ωcm, besonders bevorzugt größer als 10¹³ Ωcm.

Zum Ausgleich von Unebenheiten auf den Auflageflächen von Bodenplatte und Kopf der Elektrodenhalterung, muss der Isolierring eine Mindestbiegefestigkeit aufweisen. Die Biegefestigkeit des Isolierrings muss größer sein als (bestimmt nach DIN EN 843 für Keramik) 120 MPa, bevorzugt größer 300 MPa, besonders bevorzugt größer 800 MPa. Zusätzlich sind bei Keramiken K1C-Werte (Bruchzähigkeit nach DIN CEN/TS 14425) größer 3 MPa*m^0,5 notwendig, bevorzugt größer 4 MPa*m^0,5.

Als Materialien für den Isolierring kommen daher in Frage: Aluminiumoxid (Al₂O₃); Siliciumnitrid (Si₃N₄); Bornitrid (BN); Zirkonoxid (ZrO₂), Zirkonoxid stabilisiert mit Yttriumoxid (ZrO₂-Y₂O₃), mit Magnesiumoxid (ZrO₂-MgO) oder mit Calciumoxid (ZrO₂-CaO).

Besonders bevorzugt ist yttriumstabilisiertes Zirkonoxid, hergestellt nach dem HIP-Verfahren (heißisostatisches Pressen), da dieser Werkstoff eine Biegefestigkeit von größer als 1200 MPa bei 20°C und eine Bruchzähigkeit von > 6 MPa*m^0,5.aufweist.

Das in der Nut befindliche Dichtelement sollte einer Temperaturdauerbelastung von 320°C standhalten und gegenüber HCl/Chlorsilan-Atmosphäre bei bis zu 320°C beständig sein.

Mögliche Werkstoffe sind gegenüber oxidativen Säuren beständige FFKM (Perfluorkautschuk), Graphit und metallische Dichtungen.

Mögliche Dichtelemente aus Graphit können Graphitschnüre aus geflochtenen Graphitfasern und Graphitfolienringe sein. Ein Graphitfolienring besteht aus mehreren zusammengepressten Graphitlagen. Die Dauertemperaturbeständigkeit dieser Dichtelemente aus Graphit liegt bei bis zu 600°C.

Bei den Dichtelementen aus Graphit genügen geringe Verpresskräfte, da die Dichtfläche sehr klein ist. Die Dichtfläche wird durch die Abmessungen der Nut bestimmt. Die Dichtfläche liegt vorzugweise zwischen 600 und 3000 mm², besonders bevorzugt zwischen 600 und 2000 mm², und ganz besonders bevorzugt zwischen 600 und 1500 mm². Die Flächenpressung der Graphitdichtelemente liegt zwischen 20 - 70 N/mm², bevorzugt 25 - 50 N/mm², besonders bevorzugt 30 - 40 N/mm². Dies hat nur eine geringe mechanische Belastung auf den Isolierring zur Folge, was Brüche der Isolierringe verhindert.
In einer weiteren Ausführungsform handelt es sich um Dichtungen aus Metall.
Bei den Dichtelementen aus Metall handelt es sich vorzugweise um metallische Ringfederdichtungen. Aufgrund der geringen Dichtflächen der metallischen Dichtelemente genügt auch hier zur Abdichtung eine geringe Verpresskraft. Unter geringer Verpresskraft wird bei den Metalldichtelementen eine Verpresskraft von 60 - 300 N/mm Dichtungsumfang, bevorzugt 60 - 200 N/mm Dichtungsumfang, besonders bevorzugt 60 - 160 N/mm Dichtungsumfang verstanden.

Die metallischen Dichtungen weisen vorzugweise eine der folgenden Formen auf:
- geschlossener, innen hohler O-Ring (hohler Metall-O-Ring);
- offene Metallprofile, z.B. C-förmig, U-förmig, E-förmig oder beliebige andere Profile mit Federwirkung, z.B. wellige Metalldichtringe;
- offene Metallprofile können federgestützt sein, z.B. ein C-Ring mit zusätzlicher innenliegender Spiralfeder.

Ein C-Ring ist ein hohler O-Ring mit offener Innen- oder Außenseite.

Die metallischen Dichtelemente können zur Erhöhung der chemischen Beständigkeit und zur Erhöhung der Dichtwirkung mit duktilen Metallen beschichtet werden, z.B. mit Silber, Gold, Kupfer, Nickel oder mit einem anderen duktilen und in einer HCl / Chlorsilanatmosphäre beständigem Metall.

Durch die Fließfähigkeit dieser duktilen Beschichtungsmaterialien wird die Dichtwirkung der metallischen Dichtelemente deutlich erhöht. Die Dauertemperaturbeständigkeit dieser Dichtelemente aus Metall liegt bei bis zu 850°C.

Unter duktilen Beschichtungsmaterialien werden Metalle verstanden, bei denen sich die Korngrenzen und Versetzungen bei mechanischer Belastung schon bei einer Dehnung unterhalb der Bruchdehnung bewegen, bzw. fließen. Durch dieses Fließen bei einer Belastung unter Krafteinwirkung, wie es bei einer Verpressung gegeben ist, werden Unebenheiten der Dichtflächen ausgeglichen. Dadurch wird eine bessere Abdichtung erreicht.

Besonders bevorzugt ist die Verwendung eines mit Silber beschichteten Metall-C-Rings mit oder ohne innen liegender Spiralfeder.

Mögliche Dichtelemente aus FFKM sind O-Ringe.

Die verwendeten Flachdichtungen können aus Graphit oder PTFE, bei PTFE mit oder ohne Füllstoffe wie zum Beispiel Quarzglas oder Eisenoxyd zur Festigkeitserhöhung und Reduzierung der Fließneigung sein.

Flachdichtungen aus Graphit können zur besseren Abdichtung mit einer dünnen (kleiner 0,5mm) elastomeren Schicht (PTFE) ummantelt sein.

Zur Vermeidung eines Leckagestroms durch das Dichtungsmaterial durch Diffusion sind die Flachdichtungen am reaktorseitigen Dichtungsumfang vorzugsweise gekammert.

Dazu wird eine dünne Metallfolie, vorzugsweise aus einem gegen Halogensilane beständigen Edelstahl, besonders bevorzugt 1.4571 oder 316L, oder Silber um die zum Reaktor zeigende Dichtungsfläche gebördelt.

Die Foliendicke beträgt dabei 0,05 - 0,3 mm.

Zusätzlich kann die Flachdichtung auch am inneren Dichtungsumfang, d.h. in Richtung zum Schaft der Elektrodenhalterung zeigend, gekammert sein.

Die bezüglich der vorstehend aufgeführten Ausführungsformen des erfindungsgemäßen Verfahrens angegebenen Merkmale können entsprechend auf die erfindungsgemäße Vorrichtung übertragen werden. Umgekehrt können die bezüglich der vorstehend ausgeführten Ausführungsformen der erfindungsgemäßen Vorrichtung angegebenen Merkmale entsprechend auf das erfindungsgemäße Verfahren übertragen werden. Diese und andere Merkmale der erfindungsgemäßen Ausführungsformen werden in der Figurenbeschreibung und in den Ansprüchen erläutert. Die einzelnen Merkmale können entweder separat oder in Kombination als Ausführungsformen der Erfindung verwirklicht werden. Weiterhin können sie vorteilhafte Ausführungen beschreiben, die selbstständig schutzfähig sind.

Die Erfindung wird im Folgenden auch anhand der **Fig. 1** bis **9** erläutert.

### Kurzbeschreibung der Figuren

**Fig. 1** zeigt eine schematische Darstellung eines montierten Isolierrings mit einer Nut im Isolierring.
**Fig. 2** zeigt eine schematische Darstellung eines Isolierrings mit einer Nut.
**Fig. 3** zeigt eine schematische Darstellung einer außengebördelten Flachdichtung.
**Fig. 4a** zeigt eine schematische Darstellung eines montierten Isolierrings mit einer Nut im Isolierring sowie mit Überstand c des Kopfes der Elektrodenhalterung und einem Dichtkörper in der Nut vor der Verpressung.
**Fig. 4b** zeigt eine schematische Darstellung eines montierten Isolierrings mit einer Nut im Isolierring sowie mit Überstand c des Kopfes der Elektrodenhalterung und einem Dichtkörper in der Nut nach der Verpressung.
**Fig. 5** zeigt eine schematische Darstellung eines montierten Isolierrings mit einer Nut in der Elektrodenhalterung.
**Fig. 6** zeigt eine schematische Darstellung eines Isolierrings ohne Nut.
**Fig. 7** zeigt einen Querschnitt durch einen Metall-C-Ring.
**Fig. 8** zeigt Querschnitte durch weitere Ausführungen für Dichtelemente aus Metall.
**Fig. 9** zeigt einen Querschnitt durch einen Graphitfolienring bestehend aus mehreren verpressten Einzelfolien.

### Liste der verwendeten Bezugszeichen

- **1**: Elektrodenhalterung
- **2**: Isolierring
- **3**: Bodenplatte
- **4**: Dichtelement
- **5**: Flachdichtung
- 6: Kühlung Bodenplatte
- **7**: Zulauf Kühlung Elektrodenhalterung
- **8**: Kühlung Elektrodenhalterung
- **9**: Isolierhülse
- **10**: Nut für Dichtelement
- **11**: Bördel
- **a**: Abstand Nut von Innendurchmesser
- **b**: Gesamtbreite
- **h**: Höhe Isolierring
- **c**: Überstand der Elektrodenhalterung
- f: Überstand des Dichtelements nach der Verpressung
- F: Überstand des Dichtelements vor der Verpressung
- e: Breite des Dichtelements nach der Verpressung
- E: Breite des Dichtelements vor der Verpressung
- **D_E**: Außendurchmesser Elektrodenhalterung
- **D_R**: Außendurchmesser Isolierring

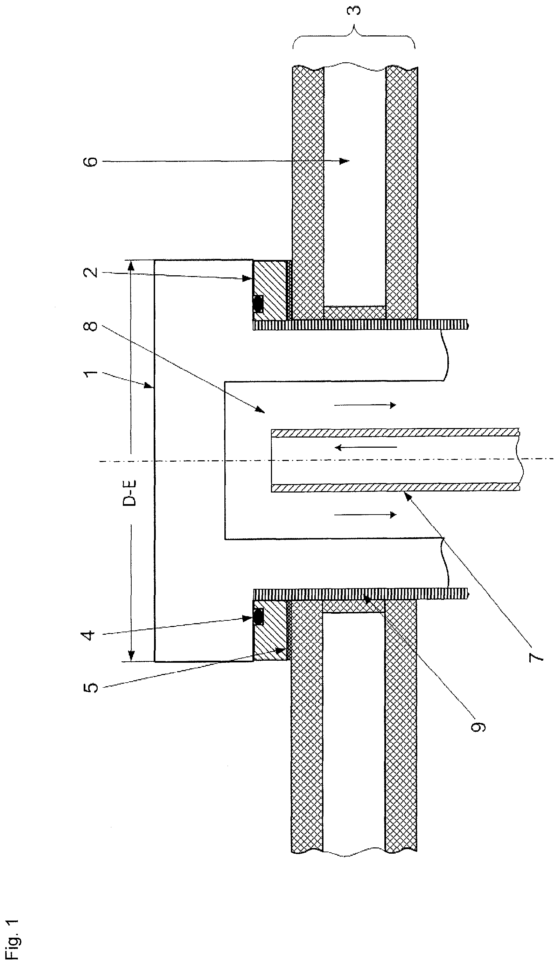

**Fig. 1** zeigt eine schematische Darstellung eines montierten Isolierrings mit einer Nut im Isolierring. Zwischen Elektrodenhalterung **1** und Bodenplatte **3** befinden sich Isolierring **2** und Dichtelement **4** sowie Flachdichtung **5.**

Die Bodenplatte **3** ist mit einer Durchbohrung versehen, die mit einer Isolierhülse **9** ausgekleidet ist und durch die eine Elektrodenhalterung **1** hindurchgeführt und eingepasst ist.

Bodenplatte **3** und Elektrodenhalterung **1** werden durch Kühlungen **6** bzw. **8** gekühlt. **7** zeigt den Zulauf für die Kühlung **7** der Elektrodenhalterung **1.**

Die Abdichtung erfolgt einerseits durch Dichtelement **4** und Flachdichtung **5.**

Dichtelement **4** befindet sich einer Nut im Isolierring 2 zur Elektrodenhalterung **1** hin Flachdichtung **5** befindet sich zwischen Isolierring **2** und Bodenplatte **3.**

Der Außendurchmesser **D_E** der Elektrodenhalterung **1** kann bezogen auf den Außendurchmesser **D_R** des Isolierrings **2** bündig oder überstehend sein. Bevorzugt ist die Elektrodenhalterung überstehend.

**Fig. 1** zeigt eine Ausführungsform ohne Überstand.

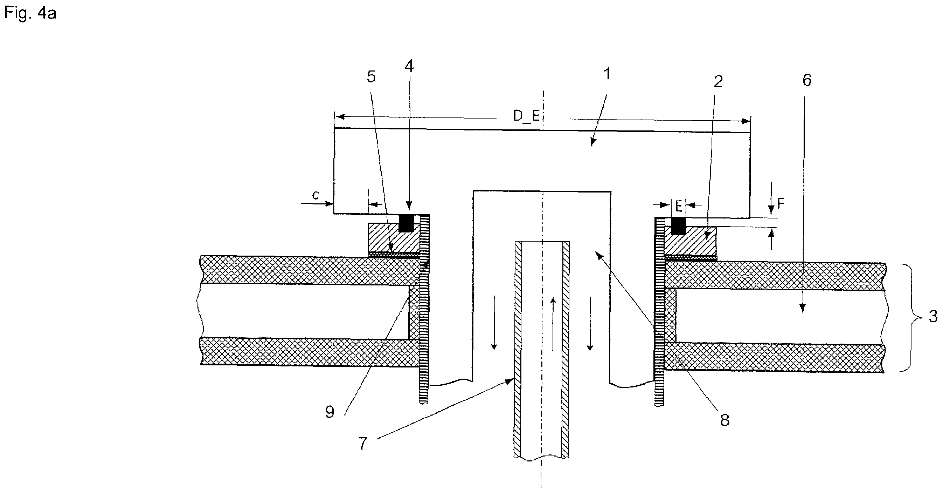

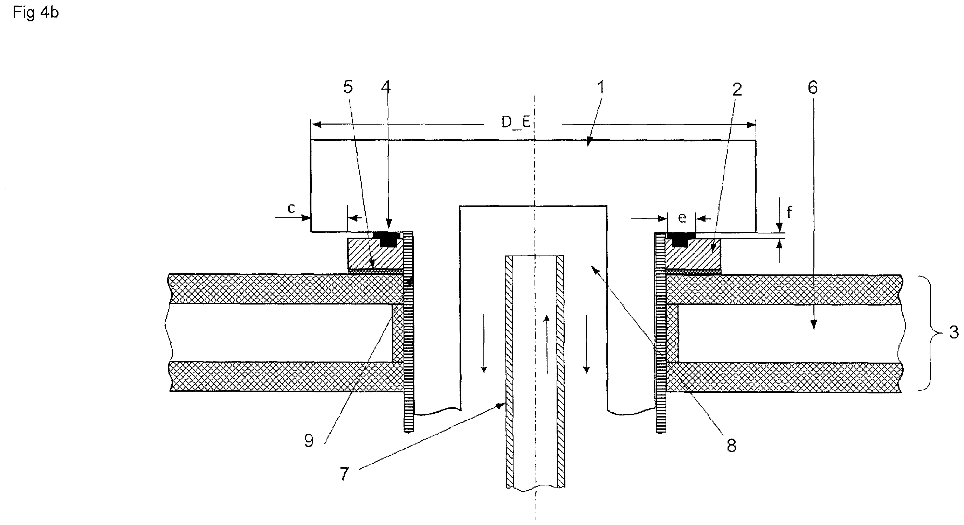

**Fig. 4a** **und b** zeigen eine Ausführungsform mit Überstand **c**

Als weiteren thermischen und mechanischen Schutz kann der Kopf der Elektrodenhalterung **1** also über die Außenkontur des Isolierrings **2** hinausragen. Der Überstand **c** sollte 0 - 8***h** betragen, wobei h der Höhe des Isolierrings **2** entspricht. Besonders bevorzugt ist ein Überstand von 0 - 4***h**.

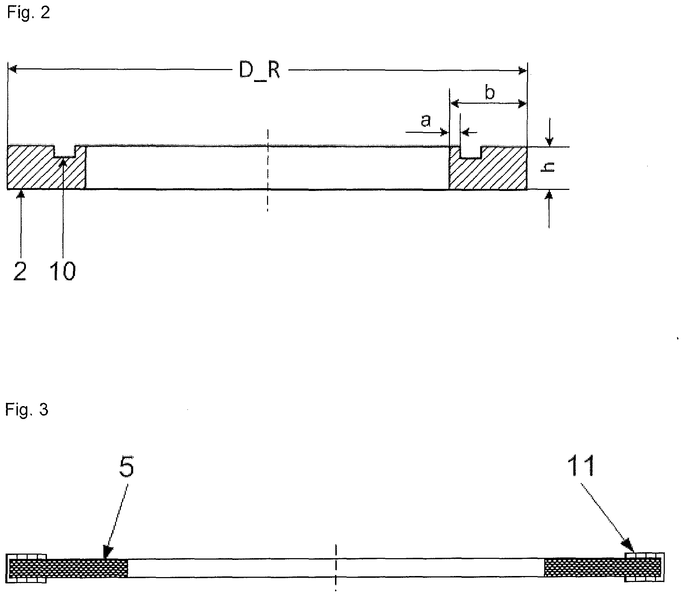

**Fig. 2** zeigt einen Isolierring **2** mit Nut **10** zur Aufnahme eines Dichtelements.
Die Nut befindet sich vorzugweise in einem Abstand a von 10-40% der Gesamtbreite b des Isolierrings zur Elektrodendurchführung (Innendurchmesser Isolierring). Dadurch ist das Dichtelement ausreichend weit von der dem Reaktor zugewandten Seite des Isolierrings entfernt. Dies ist in Hinblick auf die thermische Belastung der Dichtelemente von Vorteil.

**Fig. 3** zeigt eine außengebördelte Flachdichtung **5** mit Bördel **11**.

**Fig. 4a** zeigt eine schematische Darstellung eines montierten Isolierrings **2** mit einer Nut, in der Dichtelement 4 fixiert ist. Die Abbildung zeigt den Zustand des Dichtelements vor der Verpressung mit der Breite E des Dichtkörpers und dem Überstand F des Dichtkörpers aus der Nut im Ausgangszustand. Die Abdichtung gegenüber der Bodenplatte 3 erfolgt mittels einer Flachdichtung 5. Es handelt sich um eine Ausführungsform mit Überstand **c.**

**Fig. 4b** zeigt eine schematische Darstellung eines montierten Isolierrings **2** mit einer Nut, in der Dichtelement 4 fixiert ist. Bei dem Dichtkörper handelt es sich im Folgenden um eine Spiraldichtung oder einen Graphitfolienring. Die Abbildung zeigt den Zustand des Dichtelements nach der Verpressung mit der Breite e des Dichtkörpers nach Verpressung und dem Überstand f des Dichtkörpers aus der Nut nach der Verpressung. Die Abdichtung gegenüber der Bodenplatte 3 erfolgt mittels einer Flachdichtung 5. Es handelt sich um eine Ausführungsform mit Überstand **c.** Durch die Erhöhung der Dichtfläche aufgrund der größeren Breite e des Dichtkörpers wird die Leckage zwischen Isolierring und Dichtkörper und zwischen Dichtkörper und Elektrodenhalterung um den Faktor der Erhöhung der Dichtfläche reduziert.

Mindestens 70%, bevorzugt > 85% der Höhe des Dichtkörpers im verpressten Zustand ist in der Nut gekapselt. Eine innere Leckage durch Diffusion durch den Dichtungswerkstoff ist somit nur über max. 30% der Umfangsfläche des Dichtkörpers, bevorzugt < 15% der Umfangsfläche des Dichtkörpers in verpresstem Zustand möglich. Die größere Dichtungsbreite e des Dichtkörpers nach der Verpressung reduziert die Leckage durch den Dichtungswerkstoff weiter im Verhältnis der Dichtungsbreite e in verpresstem Zustand gegenüber der Dichtungsbreite E im unverpressten Zustand.

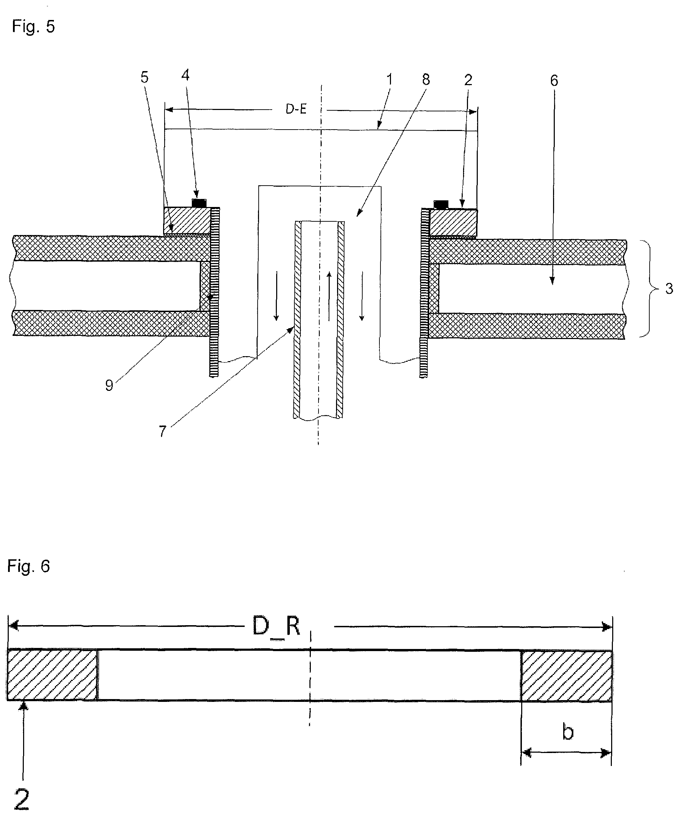

**Fig. 5** zeigt eine Ausführung, bei der sich Dichtelement **4** in einer Nut **10** in der Elektrodenhalterung **1** befindet. Die Abdichtung auf der gegenüberliegenden Seite, also zwischen Isolierring **2** und Bodenplatte **3,** erfolgt mittels einer Flachdichtung **5**.

**Fig. 6** zeigt eine schematische Darstellung eines Isolierrings **2** ohne Nut.
Ein solcher Isolierring kommt bei der Ausführung nach **Fig. 5** zum Einsatz, bei der sich die Nut zur Aufnahme des Dichtelements **4** in der Elektrodenhalterung **1** befindet.

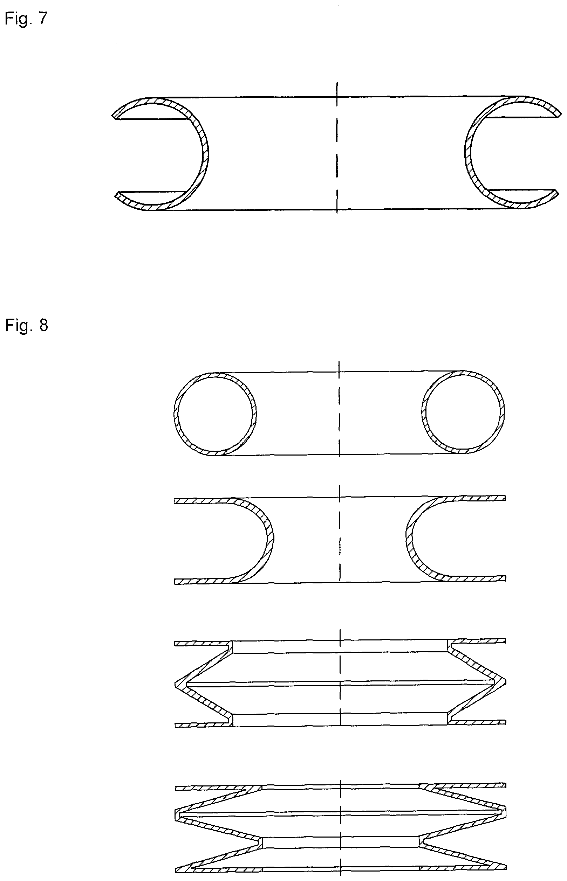

**Fig. 7** zeigt einen Querschnitt durch ein metallisches Dichtelement mit C-Profil.

**Fig. 8** zeigt Querschnitte durch weitere Ausführungen für Dichtelemente aus Metall, O-Profil, U-Profil, E-Profil, Profil mit Federwirkung.

Beim E-Ring handelt es sich um einen doppelt gefalteten Doppel-U-Ring.

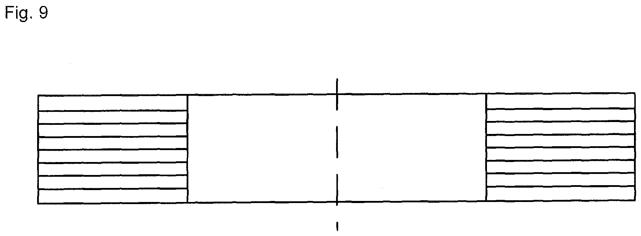

**Fig. 9** zeigt einen Querschnitt durch einen Graphitfolienring bestehend aus mehreren verpressten Einzelfolien.

### Beispiele

In einem Siemens Abscheidereaktor wurden polykristalline Siliciumstäbe mit einem Durchmesser zwischen 160 und 230 mm abgeschieden.

Dabei wurden mehrere Ausführungen an Isolierringen und Dichtelementen getestet. Die Ergebnisse dieser Tests werden nachfolgend an ausgewählten Beispielen und Vergleichsbeispielen erläutert.

Die Parameter des Abscheideprozesses waren bei allen Versuchen jeweils gleich. Die Abscheidetemperatur lag im Chargenverlauf zwischen 1000°C und 1100°C. Während des Abscheideprozesses wurde ein Feed bestehend aus einer oder mehreren chlorhaltigen Silanverbindungen der Formel SiHₙCl₄₋ₙ (mit n = 0 bis 4) und Wasserstoff als Trägergas zugegeben.

Die Versuche unterschieden sich ausschließlich in der Ausführung der Isolierringe und der Dichtelemente.

Zum Vergleich wurde zunächst ein PTFE-Isolierring untersucht, der gleichzeitig Dichtungs- und Isolierungsfunktionen übernimmt. In diesem ist also keine Funktionstrennung durch Isolierring und zusätzliche Dichtelemente vorgesehen.

Weiterhin wurden Isolierringe aus Zirkonoxid in Verbindung mit metallischen Dichtelementen getestet. Dichtelemente aus Graphit oder aus elastomeren Werkstoffen wie Perfluorelastomeren führen zu vergleichbaren Ergebnissen.

Vergleichsweise wurde eine Ausführung untersucht, bei der die Dichtelemente in Nuten des Zirkonoxid-Rings fixiert sind.

Es hat sich gezeigt, dass bei den vorteilhaften Ausführungen zumindest ein Dichtelement entweder in einer Nut der Bodenplatte oder in einer Nut der Elektrodenhalterung fixiert ist. Ein Überstand der Elektrodenhalterung gegenüber dem Isolierring kann die thermische Belastung der Dichtelemente weiter reduzieren.

### Vergleichsbeispiel

### CVD-Reaktor mit Isolierring aus PTFE:

Bei dieser Ausführungsform nach dem Stand der Technik übernimmt der Isolierring aus PTFE Dicht- und Isolierfunktion. Aufgrund der geringen Formstabilität ist die Höhe des Isolierrings auf 7 mm im Neuzustand begrenzt.

Wegen der hohen thermischen Belastung während des Betriebs und der notwendigen Presskraft von 30-40 kN zur Gewährleistung der Dichtfunktion des Isolierrings, reduzierte sich die Höhe des Isolierrings auf ein Mindestmaß von 4 mm innerhalb von 3 Monaten.

Dadurch ist die Standzeit auf 3 Monate begrenzt.

Aufgrund der thermischen Belastung durch das heiße Reaktionsgas war sowohl die Abdichtung der Bodenplatte als auch die elektrische Isolation durch thermisches Cracken und Setzen des Dichtkörpers nicht mehr gegeben. Nach dieser Zeit war deshalb ein aufwendiger Tausch aller Isolierringe notwendig. Reparaturarbeiten hatten einen erheblichen Kapazitätsverlust zur Folge.

### Beispiel

### CVD-Reaktor mit Isolierring aus Zirkonoxid (ZrO2):

Bei dieser Ausführung wird die Dicht- und Isolierfunktion auf zwei Bauteile aufgeteilt. Der Isolierring aus ZrO₂ wird zur elektrischen Isolierung zwischen Elektrodenhalterung und Bodenplatte eingesetzt. Der Isolierring ist 8 mm hoch im Neuzustand.

Der Isolierring hat zum Kopf der Elektrodenhalterung hin eine Nut. Die Dichtfunktion übernimmt jeweils ein Graphitfolienring in der Nut und zur Bodenplatte eine Graphitflachdichtung mit Metallbördel, der zum Reaktionsraum hin gerichtet ist. ZrO2 hat als Keramikbauteil kein Setzverhalten. Der Grafitfolienring hatte nach der Verpressung noch einen Überstand f zwischen Kopf der Elektrodenhalterung und Isolierring von 0,3 mm. Der Graphitfolienring wurde mit einer Flächenpressung von 35 N/mm² verpresst. Nach 12 Monaten wurde der Isolierring im Zuge von wiederkehrenden Wartungszyklen getauscht. Die Breite e des Graphitfolienrings außerhalb der Nut betrug das 1,6 fache der Breite E des Grafitfolienrings in der Nut des Stützrings. Durch die sehr hohe Temperaturbeständigkeit und die deutlich höhere spezifische Wärmeleitfähigkeit gegenüber PTFE waren die zum Reaktor zugewandte Seite des Isolierrings sowie der Graphitfolienring und die Flachdichtung nicht thermisch angegriffen. Nach dem Tausch der Elektrodenhalterungen wurden keine Kieselsäureablagerungen am Schaft der Elektrodenhalterungen festgestellt. Die Standzeit erhöhte sich auf 12 Monate. Das Dichtsystem, Isolierring und Dichtelemente, ist somit für die Standzeit nicht mehr limitierend.

Die vorstehende Beschreibung beispielhafter Ausführungsformen ist exemplarisch zu verstehen. Die damit erfolgte Offenbarung ermöglicht es dem Fachmann einerseits, die vorliegende Erfindung und die damit verbundenen Vorteile zu verstehen, und umfasst andererseits im Verständnis des Fachmanns auch offensichtliche Abänderungen und Modifikationen der beschriebenen Strukturen und Verfahren. Daher sollen alle derartigen Abänderungen und Modifikationen sowie Äquivalente durch den Schutzbereich der Ansprüche abgedeckt sein.

## Patentansprüche

1. Vorrichtung zur Isolierung und Abdichtung von Elektrodenhalterungen (1) befindlich in CVD Reaktoren, umfassend eine zur Aufnahme eines Filamentstabs geeignete Elektrode auf einer Elektrodenhalterung (1) aus einem elektrisch leitfähigen Material, die in einer Aussparung einer Bodenplatte (3) angebracht ist, wobei zwischen Elektrodenhalterung (1) und Bodenplatte (3) ein elektrisch isolierender Ring (2) aus einem Werkstoff mit einer spezifischen Wärmeleitfähigkeit bei Raumtemperatur von 0,2 - 50 W/mK einer Mindestbiegefestigkeit von größer als 120 MPa und einem spezifischen elektrischen Widerstand bei Raumtemperatur von größer als 10⁹ Ωcm vorgesehen ist, wobei mindestens zwei ringförmige Dichtelemente (4, 5) zur Abdichtung zwischen Elektrodenhalterung (1) und Bodenplatte (3) vorhanden sind, wobei die mindestens zwei ringförmigen Dichtelemente (4, 5) nicht auf derselben Seite des elektrisch isolierenden Rings (2) liegen und wobei der elektrisch isolierende Ring (2) oder die Elektrodenhalterung (1) oder die Bodenplatte (3) wenigstens eine Nut (10) umfasst, in denen ein erstes Dichtelement (4) fixiert ist, **dadurch gekennzeichnet, dass** wenigstens ein zweites nicht in einer Nut fixiertes Dichtelement (5) zwischen elektrisch isolierendem Ring (2) und Bodenplatte (3) oder zwischen elektrisch isolierendem Ring (2) und Elektrodenhalterung (1) vorhanden ist.

2. Vorrichtung nach Anspruch 1, wobei der Werkstoff des elektrisch isolierenden Rings ausgewählt wird aus der Gruppe bestehend aus Aluminiumoxid, Siliciumnitrid, Bornitrid, Zirkonoxid und mit Yttriumoxid, mit Magnesiumoxid oder mit Calciumoxid stabilisiertem Zirkonoxid.

3. Vorrichtung nach Anspruch 1 oder nach Anspruch 2, wobei es sich beim ersten Dichtelement um einen Graphitfolienring handelt.

4. Vorrichtung nach Anspruch 1 oder nach Anspruch 2, wobei es sich beim ersten Dichtelement um einen metallischen O-Ring oder um eine metallische Dichtung mit einem offenen Profil mit Federwirkung handelt.

5. Vorrichtung nach Anspruch 4, wobei die metallische Dichtung ein C-Profil aufweist und mit Silber beschichtet ist.

6. Vorrichtung nach einem der Ansprüche 1 bis 5, wobei es sich beim zweiten Dichtelement um eine Flachdichtung aus Graphit oder PTFE handelt.

7. Vorrichtung nach Anspruch 6, wobei die Flachdichtung am reaktorseitigen Dichtungsumfang gekammert ist, indem Metall- oder Silberfolie um die reaktorseitige Dichtungsfläche der Flachdichtung gebördelt ist.

8. Verfahren zur Herstellung von polykristallinem Silicium, umfassend Einleiten eines Reaktionsgases enthaltend eine Silicium enthaltende Komponente und Wasserstoff in einen CVD Reaktor enthaltend wenigstens einen Filamentstab, der sich auf einer Vorrichtung gemäß einem der Ansprüche 1 bis 7 befindet, der mittels der Elektrode mit Strom versorgt und der damit durch direkten Stromdurchgang auf eine Temperatur aufgeheizt wird, bei der sich polykristallines Silicium am Filamentstab abscheidet.

## Claims

1. Apparatus for insulating and sealing electrode holders (1) situated in CVD reactors which comprises an electrode which is suitable for accommodating a filament rod and is disposed atop an electrode holder (1) made of an electrically conductive material and mounted in a recess in a floor plate (3), wherein provided between the electrode holder (1) and the floor plate (3) is an electrically insulating ring (2) made of a material of construction having a specific thermal conductivity at room temperature of 0.2 - 50 W/mK, a minimum flexural strength of greater than 120 MPa and a specific electrical resistance at room temperature of greater than 10⁹ Ωcm, wherein at least two ring-shaped sealing elements (4, 5) for sealing between the electrode holder (1) and the floor plate (3) are present, wherein the at least two ring-shaped sealing elements (4, 5) do not lie on the same side of the electrically insulating ring (2) and wherein the electrically insulating ring (2) or the electrode holder (1) or the floor plate (3) comprises at least one groove (10) in which a first sealing element (4) is secured, **characterized in that** at least one second sealing element (5) not secured in a groove is present between the electrically insulating ring (2) and the floor plate (3) or between the electrically insulating ring (2) and the electrode holder (1).

2. Apparatus according to Claim 1, wherein the material of construction of the electrically insulating ring is selected from the group consisting of aluminum oxide, silicon nitride, boron nitride, zirconium oxide and yttrium-oxide-, magnesium-oxide- or calcium-oxide-stabilized zirconium oxide.

3. Apparatus according to Claim 1 or according to Claim 2, wherein the first sealing element is a graphite foil ring.

4. Apparatus according to Claim 1 or according to Claim 2, wherein the first sealing element is a metallic O-ring or a metallic seal having an open profile having a spring action.

5. Apparatus according to Claim 4, wherein the metallic seal has a C-profile and is coated with silver.

6. Apparatus according to any of Claims 1 to 5, wherein the second sealing element is a gasket made of graphite or PTFE.

7. Apparatus according to Claim 6, wherein the gasket is chambered on the reactor-side seal circumference as a result of metal or silver foil being flanged around the reactor-side sealing surface of the gasket.

8. Process for producing polycrystalline silicon, comprising introducing a reaction gas comprising a silicon-comprising component and hydrogen into a CVD reactor comprising at least one filament rod which is disposed atop an apparatus according to any of Claims 1 to 7, which is supplied with current via the electrode and which is thus heated by direct passage of current to a temperature at which polycrystalline silicon is deposited on the filament rod.

## Revendications

1. Dispositif pour isoler et rendre étanche des porte-électrodes (1) qui se trouvent dans des réacteurs CVD, comprenant une électrode, adaptée pour accueillir une tige de filament, sur un porte-électrode (1) en un matériau électriquement conducteur, qui est logée dans un évidement d'une plaque de fond (3), une bague (2) électriquement isolante en un matériau ayant une conductivité thermique spécifique à température ambiante de 0,2 - 50 W/mK, une résistance à la flexion minimale supérieure à 120 MPa et une résistance électrique spécifique à température ambiante supérieure à 10⁹ Ωcm se trouvant entre le porte-électrode (1) et la plaque de fond (3), au moins deux éléments d'étanchéité (4, 5) de forme annulaire destinés à réaliser l'étanchéité entre le porte-électrode (1) et la plaque de fond (3) étant présents, les au moins deux éléments d'étanchéité (4, 5) de forme annulaire n'étant pas disposés du même côté de la bague (2) électriquement isolante et la bague (2) électriquement isolante ou le porte-électrode (1) ou la plaque de fond (3) comportant au moins une rainure (10) dans laquelle est calé un premier élément d'étanchéité (4), **caractérisé en ce qu'**au moins un deuxième élément d'étanchéité (5), non calé dans une rainure, se trouve entre la bague (2) électriquement isolante et la plaque de fond (3) ou entre la bague (2) électriquement isolante et le porte-électrode (1).

2. Dispositif selon la revendication 1, le matériau de la bague électriquement isolante étant choisi dans le groupe composé de l'oxyde d'aluminium, du nitrure de silicium, du nitrure de bore, de l'oxyde de zircon et de l'oxyde de zircon stabilisé avec de l'oxyde d'yttrium, avec de l'oxyde de magnésium ou avec de l'oxyde de calcium.

3. Dispositif selon la revendication 1 ou selon la revendication 2, le premier élément d'étanchéité étant une bague en film de graphite.

4. Dispositif selon la revendication 1 ou selon la revendication 2, le premier élément d'étanchéité étant un joint torique métallique ou une garniture d'étanchéité métallique ayant un profil ouvert avec effet de ressort.

5. Dispositif selon la revendication 4, la garniture d'étanchéité métallique présentant un profil en C et étant revêtue d'argent.

6. Dispositif selon l'une des revendications 1 à 5, le deuxième élément d'étanchéité étant un joint plat en graphite ou en PTFE.

7. Dispositif selon la revendication 6, le joint plat étant encastré au niveau du pourtour de garniture d'étanchéité côté réacteur en ce qu'un film de métal ou d'argent est bordé autour de la surface d'étanchéité côté réacteur du joint plat.

8. Procédé de fabrication de silicium polycristallin, comprenant l'introduction d'un gaz de réaction contenant une composante contenant du silicium et de l'hydrogène dans un réacteur CVD contenant au moins une tige de filament, laquelle se trouve sur un dispositif selon l'une des revendications 1 à 7, laquelle est alimentée en électricité au moyen de l'électrode et laquelle est ainsi chauffée par passage direct du courant à une température à laquelle le silicium polycristallin se dépose sur la tige de filament.
